# FASCICULE DE BREVET EUROPEEN

(11) **EP 0 843 889 B1**
(45) Date de publication et mention de la délivrance du brevet: **29.09.2004**
(21) Numéro de dépôt: 96924926.7
(22) Date de dépôt: 03.07.1996
(51) Int. Cl.: H01L 21/66

(54) **DISPOSITIF ET PROCEDE DE TRAITEMENT DE SURFACE PAR LASER**
VORRICHTUNG UND VERFAHREN ZUR LASER-OBERFLÄCHENBEHANDLUNG
LASER SURFACE TREATMENT DEVICE AND METHOD

(30) Priorité: 11.08.1995 FR 9509778
(43) Date de publication de la demande: 27.05.1998
(73) Titulaire: Société de Production et de Recherches Appliquées, 92270 Bois-Colombes (FR)
(72) Inventeur: BOHER, Pierre, F-91330 Yerres (FR); STEHLE, Marc, F-92190 Meudon (FR)
(74) Mandataire: Plaçais, Jean-Yves
(86) Numéro de dépôt international: PCT/FR1996/001034
(87) Numéro de publication internationale: WO 1997/007539

(56) Documents cités:
- EP-A- 0 252 262
- EP-A- 0 631 304
- US-A- 5 313 044
- PATENT ABSTRACTS OF JAPAN vol. 94, no. 010 & JP,A,06 288835 (SHIMADZU CORP), 18 Octobre 1994,
- PATENT ABSTRACTS OF JAPAN vol. 16, no. 134 (E-1185), 6 Avril 1992 & JP,A,03 295251 (SUMITOMO ELECTRIC)
- PATENT ABSTRACTS OF JAPAN vol. 9, no. 19 (E-292), 25 Janvier 1985 & JP,A,59 168636 (TOSHIBA KK)

## Description

L'invention se rapporte au traitement de surface par laser, et à son contrôle.

Elle trouve une application particulière au recuit d'échantillons en silicium amorphe par laser excimère.

D'une façon générale, l'application d'un faisceau laser sur une surface a pour but de modifier ladite surface, sa structure et son état.

En pratique, le mécanisme mis en jeu est une fusion partielle de la surface, dans le cas de la cristallisation du silicium amorphe.

La Demanderesse s'est posé le problème de fournir des dispositif et procédé capables de contrôler, en temps réel, sur site, rapidement et de façon non destructive un traitement de surface par laser dans lequel on dispose d'au moins deux domaines superficiels généralement semblables à traiter, de profondeur donnée, sur chacun desquels doit être appliqué, en une ou plusieurs fois, un faisceau laser de traitement, de caractéristiques choisies pour changer l'état physique de chaque domaine superficiel.

La présente invention apporte une solution à ce problème/ et pourvoit un procédé selon la revendication 1 et un dispositif selon la revendication 12.

Selon une définition générale de l'invention, le procédé se caractérise par le fait d'effectuer au moins une mesure d'ellipsométrie avant l'une au moins des applications du faisceau de traitement sur le second domaine superficiel, en au moins une zone du premier domaine superficiel, afin d'obtenir une caractérisation dudit premier domaine superficiel, ce qui permet de contrôler en temps réel, sur site, de façon non destructive et rapidement, le changement d'état physique de chaque domaine superficiel à l'aide de ladite caractérisation.

Selon un mode de réalisation de l'invention, la mesure d'ellipsométrie est spectroscopique.

Selon un autre mode de réalisation de l'invention, la mesure d'ellipsométrie est effectuée à une ou quelques longueurs d'ondes.

On connaît l'analyse optique dite "ellipsométrie spectroscopique" habituellement utilisée dans le domaine de la recherche et du développement. Ce genre d'analyse permet la caractérisation d'une monocouche ou d'empilement multicouches dans une gamme d'épaisseurs relativement large.

Il serait donc théoriquement possible d'utiliser une telle analyse optique pour contrôler le changement d'état physique d'une surface obtenu par laser. Mais, entre autres facteurs, la complexité, le coût d'une telle analyse, le temps qu'elle nécessite, et l'encombrement du laser et de l'ellipsomètre, font que les hommes du métier n'ont pas songé jusqu'à présent à la mettre en oeuvre dans cette application, de façon industrielle.

La Demanderesse a observé que l'on peut faire en sorte que le domaine d'analyse de l'ellipsométrie recouvre sensiblement (en profondeur, mais ponctuellement) le domaine superficiel à trois dimensions (souvent appelé ci-après "surface", pour simplifier) qui est concerné par l'impact du faisceau laser. Ceci ouvre de nombreuses possibilités de contrôle du traitement des différentes couches de ladite surface. En outre, il a été observé que cette analyse et le traitement laser peuvent être mis en oeuvre selon des conditions de travail généralement semblables par des moyens de métrologie et/ou optiques relativement simples et peu coûteux, ce qui facilite l'obtention d'un encombrement réduit, et contribue encore à diminuer les coûts de mise en oeuvre des procédé et dispositif de l'invention.

De plus, la Demanderesse a observé que l'intervalle de temps compris entre deux applications d'un faisceau laser de forte puissance permet d'effectuer au moins une mesure d'ellipsométrie entre lesdites applications laser.

La Demanderesse a observé également que la caractérisation physico-chimique par ellipsométrie permet non seulement un contrôle, fait avant et/ou après le traitement par laser, mais aussi l'optimisation de certains au moins des paramètres dudit traitement laser.

Selon l'invention, cette optimisation du traitement par laser s'effectue selon une loi prédéterminée dépendant au moins en partie de ladite caractérisation physico-chimique avant chaque étape du traitement laser.

En pratique, l'un des paramètres de l'optimisation du traitement par laser est l'énergie appliquée par le faisceau laser par unité de surface et/ou par unité de temps.

Par exemple, l'optimisation du traitement par laser consiste à ajuster l'énergie par unité de surface et/ou par unité de temps apportée par la source laser afin d'obtenir un faisceau laser approprié au domaine superficiel à traiter, conformément à la caractérisation de ce domaine obtenue par ellipsométrie spectroscopique. Plus précisément, cet ajustement consiste à faire varier l'énergie du faisceau laser, optiquement et/ou mécaniquement et/ou électriquement.

D'autres caractéristiques et avantages de l'invention apparaîtront à la lumière de la description et des dessins dans lesquels:
- la figure 1 est un schéma de principe de l'installation de contrôle du recuit de panneaux en silicium amorphe par laser excimère ;
- la figure 2 est une représentation schématique d'un ellipsomètre spectroscopique .associé à un traitement de surface par laser excimère ;
- la figure 3 représente des courbes de cristallinité du recuit laser de plusieurs types d'échantillons (avec ou sans couche antiréflectrice) effectuées à température ambiante ou à 240°C ; et
- la figure 4 est un organigramme illustrant le fonctionnement du contrôle du recuit de panneaux en silicium amorphe par laser excimère.

La description ci-après s'appuie, non limitativement, sur une application particulière de la présente invention qui concerne la fabrication d'écrans à cristaux liquides à matrice active, appelés encore AMLCD pour "Active Matrix Liquid Crystal Displays", et plus précisément l'étape qui consiste à fabriquer des transistors en polysilicium (polysilicon thin film transistor, TFT), nécessaires aussi bien à la réalisation des circuits de pilotage de l'écran qu'aux éléments d'affichage.

L'étape de fabrication des transistors détermine les performances des écrans, notamment la vitesse d'affichage qui est directement proportionnelle à la vitesse à laquelle sont capables de travailler les circuits de contrôle de l'écran et donc à la mobilité des porteurs de charge électrique dans le matériau constituant les transistors TFT.

Le problème posé par la fabrication des transistors en polysilicium sur des grands substrats de verre est la température de traitement qui ne doit jamais excéder la température critique du substrat au-delà de laquelle il perd ses propriétés (essentiellement mécaniques). Cette température est de l'ordre de 600°C pour des substrats de verre courant (593°C pour du verre CORNING de référence 7059 F par exemple).

Or, actuellement, on ne sait pas directement déposer du polysilicium à cette température. La seule solution connue consiste à déposer une couche de silicium amorphe et à recristalliser celle-ci par apport d'énergie sur la couche elle-même, sans excéder la température de destruction du substrat. La cristallisation spontanée du silicium amorphe se produit, pour des températures de l'ordre de 900°C. Il s'agit donc de transmettre une énergie suffisante à la couche sans élever de façon excessive la température du substrat.

Une première solution connue consiste à effectuer un recuit thermique de longue durée. Plus précisément, il s'agit de maintenir, sous atmosphère contrôlée, les panneaux à une température juste inférieure à la température de dégradation du substrat (typiquement 600°C), pendant plusieurs heures. Par exemple, après 12 h de recuit, la cristallisation en phase solide est obtenue. Toutefois, une telle technique a l'inconvénient de présenter une capacité de production limitée. De plus, les performances du polysilicium ainsi produit ne sont pas optimales en termes de mobilité et de courant de fuite des transistors que l'on créera ensuite, probablement parce que la cristallisation en phase solide n'est jamais complète ici.

Une autre solution connue consiste à utiliser la technique dite "recuit thermique rapide", appelée encore RTP pour "Rapid Thermal Processing". Il s'agit d'effectuer un recuit thermique rapide à haute température en limitant autant que possible le chauffage du substrat tout en favorisant l'élévation de température de la couche de silicium amorphe. Par exemple, ce préchauffage est obtenu par une batterie de lampes infrarouges disposée à proximité des panneaux. Maintenus constamment en mouvement, les panneaux sont préchauffés à 500°C, sous atmosphère d'azote à la pression atmosphérique, par la batterie de lampes infrarouges dont l'énergie est absorbée par le verre. Ce préchauffage permet de réduire le choc thermique produit par un faisceau de lumière généré par une lampe xénon à haute énergie, dont l'énergie est préférentiellement absorbée par la couche de silicium. Cet échauffement additionnel, jusqu'à une température de l'ordre de 750°C est localisé sur une bande d'environ 1 cm de large sur le substrat grâce à un système sophistiqué de focalisation optique.

Même si ce procédé est rapide, l'homogénéité du traitement est toutefois difficile à contrôler, spécialement sur de grandes surfaces. De plus, les propriétés du substrat peuvent être dégradées par une augmentation trop forte de température, due à une diffusion thermique.

Enfin, une troisième solution connue consiste à exploiter l'absorption particulièrement forte du silicium dans l'ultra-violet, alors que le verre est complètement transparent aux mêmes longueurs d'ondes. Il s'agit alors d'utiliser un faisceau laser pulsé de forte puissance permettant d'élever sélectivement la température de la couche de silicium amorphe jusqu'à la fusion, sans affecter le substrat.

Le procédé a l'avantage de pouvoir être conduit très rapidement (la durée moyenne d'une impulsion d'un laser excimère à 308 nanomètres est généralement inférieure à 200 nanosecondes). Il en résulte que les effets parasites de chauffage du substrat par conduction thermique sont négligeables. De plus, le traitement est appliqué à la température ambiante sans précautions particulières (à pression atmosphérique).

Par ailleurs, un traitement limité à certaines zones des panneaux est ici possible, ce qui permet d'envisager une technologie hybride à la fois sur silicium amorphe et polysilicium.

Toutefois, une telle technologie est délicate sur deux points : il faut assurer un traitement homogène sur de grandes surfaces, et il faut maîtriser complètement le processus physique de fusion-solidification par impulsions laser.

Pour chercher à assurer un traitement homogène sur de grandes surfaces, il est connu d'utiliser un laser excimère de puissance moyenne (500 mJ par. impulsion), et de balayer la surface de l'échantillon à traiter par une série d'impacts laser de largeur très faible (1 µm). Les lignes ainsi balayées se recouvrent partiellement et couvrent ainsi, de proche en proche, toute la surface nécessaire à éclairer.

Toutefois, cette solution présente l'inconvénient de nécessiter des milliers d'impacts laser sur un seul substrat, et donc une cadence de fonctionnement du laser importante (au moins 500 Hz) pour obtenir un temps opératoire global raisonnable. Cette cadence est critique pour la maintenance et la durée de vie des équipements, en particulier les composants consommables.

Pour chercher à assurer un traitement homogène sur de grandes surfaces, il est également connu d'utiliser un laser excimère à forte puissance, par exemple un laser excimère à préionisation par rayons X fournissant une puissance effective de 1 kW (10 J x 100 Hz ou 13 J x 80 Hz). Ce type de laser permet d'obtenir un faisceau laser de forte puissance avec un taux de répétition plus faible que celui précédemment décrit, ce qui autorise un traitement sur une surface importante, voire jusqu'à l'intégralité de chaque panneau, en une seule impulsion laser.

La suite se place dans ce contexte. Comme déjà indiqué , on appelle "domaine superficiel" l'ensemble de la partie à traiter de l'échantillon; on appelle "zone" la partie de ce domaine traitée en une passe du laser. Par ailleurs, on entend par "deux domaines superficiels à traiter généralement semblables" deux domaines superficiels qui appartiennent soit à deux panneaux distincts, généralement semblables ; soit au même panneau.

Le problème consistant à maîtriser parfaitement le processus physique de fusion-cristallisation par impulsions laser sur au moins deux domaines superficiels généralement semblables, est résolu selon l'invention par un procédé selon la revendication 1.

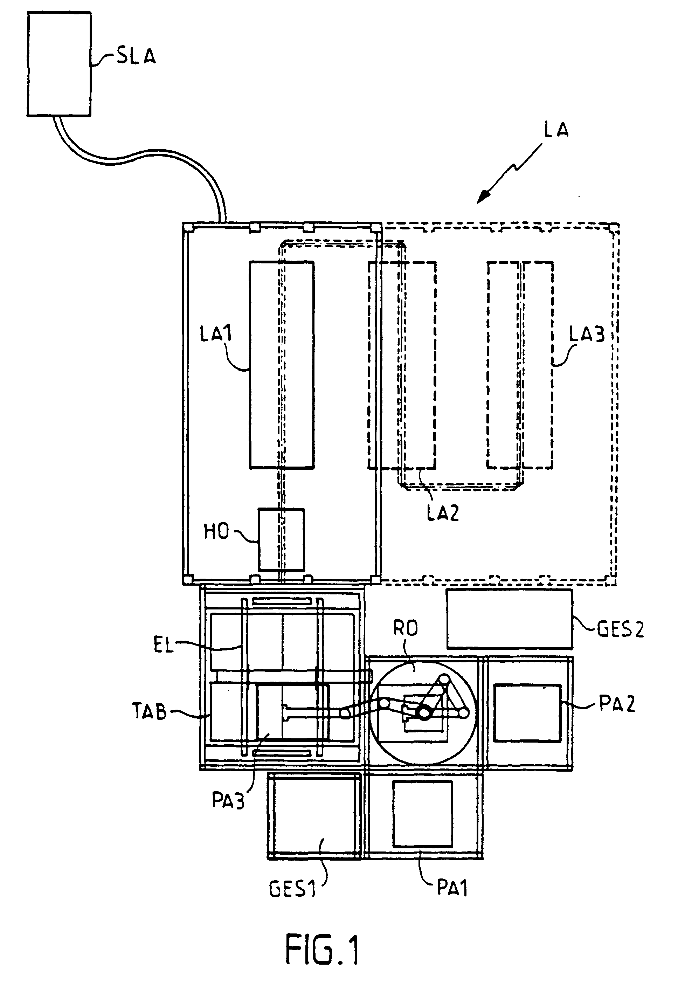

En référence à la figure 1, le dispositif mettant en oeuvre le procédé selon l'invention comprend une source laser LA possédant une alimentation SLA et une pluralité de têtes laser excimère, individualisées en LA1 à LA3. Les têtes laser sont de forte puissance et positionnées de façon à produire un seul faisceau laser de très forte puissance, par exemple de 45 J. La tête LA1 est représentée en traits forts tandis que les têtes LA2 et LA3 sont représentées en traits tiretés dans la mesure où elles sont optionnelles. La ou les sources laser sont du type XeCl d'une longueur d'onde de 308 nm, par exemple.

Cette source laser est décrite dans la Demande de Brevet FR-A-2 737 814 intitulée "Procédé et dispositif de commande d'une source laser à plusieurs modules laser pour optimiser le traitement de surface par laser", déposée par la Demanderesse le même jour que la présente Demande sous le N° 95 09780.

Très avantageusement, le faisceau laser est adapté à la taille de zone souhaitée et en même temps homogénéisé par un dispositif à micro-lentilles HO décrit en détail dans la Demande de Brevet FR-A- 2 737 786 intitulée "Dispositif optique pour homogénéiser un faisceau laser", déposée par la Demanderesse le même jour que la présente Demande sous le N° 95 09781.

L'installation est complétée par un système de gestion électronique GES1 et GES2 pilotant un robot RO qui assure le déplacement des panneaux, une table TAB en x, y, z, et un ellipsomètre EL, qui peut être spectroscopique. Cet ellipsomètre EL peut réaliser à la fois le contrôle du positionnement des panneaux par rapport au faisceau laser, et le contrôle en temps réel de l'évolution du traitement des panneaux par laser.

Il est précisé que l'ellipsométrie spectroscopique est un procédé optique non destructif de caractérisation d'empilements multicouches, applicable dans une couche d'épaisseur assez large, allant par exemple de 0,1 nanomètre à 10 µm.

La mesure est basée sur la variation de polarisation d'un faisceau de lumière après réflexion sur la surface de l'échantillon à analyser. On en vient aux épaisseurs en considérant le contraste d'indices entre couches de matériaux différents.

Avantageusement, la caractérisation physico-chimique du domaine superficiel comprend la mesure d'au moins un des paramètres appartenant au groupe formé par l'épaisseur de ce domaine, la densité et l'indice optique de ce domaine, l'épaisseur des différentes couches constituant la surface, et la composition physico-chimique de ce domaine. L'ensemble des grandeurs mesurées, pour une application donnée, peut être appelé "multiplet de caractéristiques physico-chimiques".

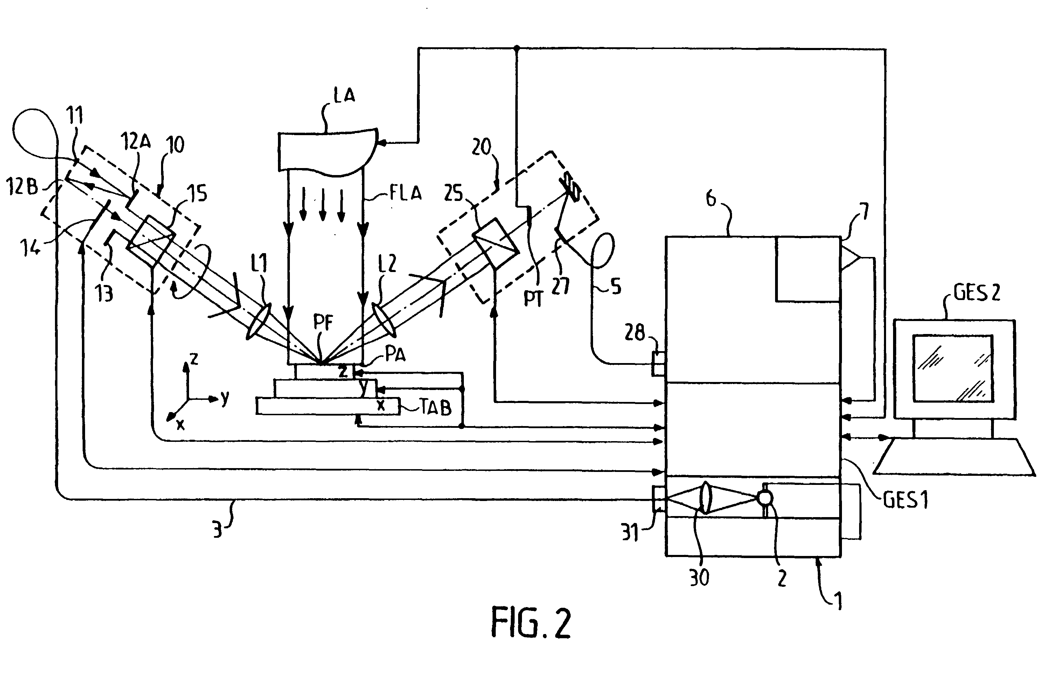

En référence à la figure 2, La référence EL désigne un ellipsomètre spectroscopique, par exemple celui vendu par la Demanderesse, sous les références commerciales ES4G, MLM, ou GESP5. Un tel ellipsomètre est décrit, au moins dans son principe, par exemple dans le Brevet français N°8603188 publié en FR-A-2 595 471.

Une alimentation 1 excite une source de lumière 2, telle qu'une lampe à arc au xénon haute pression. Un premier système optique 10, comportant des moyens 15 propres à agir sur la polarisation, transforme le faisceau de lumière issu de la source 2, en un faisceau qui frappe un panneau PA monté sur la table TAB, de préférence mobile suivant trois directions orthogonales entre elles X, Y, et Z.

La lumière utile est celle réfléchie par le panneau, symétriquement du faisceau incident par rapport à une normale à la surface du panneau.

Cette lumière réfléchie est reprise par un second système optique 20 comprenant un analyseur 25, pour être appliquée à la fente d'entrée d'un monochromateur à prisme 6. La lumière issue de la fente de sortie du monochromateur 6 est appliquée à un photodétecteur 7 comprenant une barrette de photodiodes, par exemple 512 ou 1024 pixels, permettant d'effectuer la détection en longueur d'onde (ou bien un photodétecteur mono-voie, dans le cas d'un ellipsomètre non spectroscopique).

Une électronique de commande GES1 agit:
- sur les moyens de polarisation 15, pour en commander ses effets sur la polarisation de la lumière incidente, (en présence de moyens de polarisation de type polariseur tournant, l'électronique de commande agit sur la mise en rotation continue du polariseur),
- sur la table TAB, pour en commander le positionnement en X-Y-Z,
- sur le robot ROB pour commander d'abord l'extraction d'un panneau à traiter du présentoir dans lequel sont rangés les panneaux à traiter, ensuite le déplacement du panneau ainsi extrait vers la table, puis le positionnement dudit panneau sur la table à un emplacement choisi, et, après l'ellipsométrie (en un ou plusieurs emplacements), la préhension du panneau pour le replacer dans le présentoir initial ou dans un autre présentoir de rangement,
- sur l'analyseur 25, pour en commander l'orientation à travers un moteur pas à pas,
- sur le monochromateur 6, pour en définir la longueur d'onde d'accord,
- sur la source laser LA, pour en contrôler la fluence selon l'invention.

Le signal issu du photodétecteur 7 est appliqué aux moyens de gestion GES1 pour être enregistré en relation avec l'état de polarisation de la lumière incidente (par exemple, l'angle du polariseur 15 dans le cas d'un polariseur tournant), et d'autres données recueillies dont notamment la position du panneau à traiter, celle de l'analyseur et la longueur d'onde à laquelle correspond chaque mesure.

Ces informations, éventuellement prétraitées par l'électronique GES1, sont transmises à des moyens de traitement GES2 tel qu'un micro-ordinateur qui en déduit les informations d'ellipsométrie (par exemple "tangente psi" et "cosinus delta"), puis des courbes représentatives de l'état de surface et/ou de la structure multicouches du panneau à traiter, en fonction de chaque position d'impact du spot d'analyse d'ellipsométrie.

Un châssis, de préférence unique, comprend l'alimentation 1 de la lampe au xénon 2, les moyens de gestion GES1, le monochromateur 6, le détecteur 7 et le cas échéant les moyens de traitement GES2.

En pratique, le rayonnement lumineux de la source 2 est transmis par une lentille 30 au coupleur d'entrée 31 d'une fibre optique 3. Celle-ci rejoint le système optique 10, qui comprend un coupleur de sortie de fibre 11, une lentille 12, un diaphragme de collimation 13, et le polariseur 15.

Le faisceau parallèle issu du polariseur 15 est focalisé par une lentille convergente L1 sur un point focal PF du panneau à traiter. La lentille L1 est disposée au niveau du plan objet du panneau.

Le rayonnement réfléchi est focalisé par une autre lentille convergente L2 sur le coupleur d'entrée 27 de la seconde fibre optique 5. La lentille L2 est disposée au niveau du plan image du panneau. Les lentilles L1 et L2 sont conjuguées optiquement.

Le coupleur de sortie 28 de la fibre optique 5 délivre un rayonnement repris par une lentille 29 pour être appliqué sur la fente d'entrée du monochromateur 6.

En regard de la fente de sortie du monochromateur, se trouve le détecteur 7.

Le montage optique constitué par les lentilles L1 et L2 permet d'éliminer la réflexion parasite provoquée systématiquement par la face arrière d'un échantillon comprenant un substrat de verre d'une épaisseur importante.

Cette suppression mécanique de la contribution de la face arrière de l'échantillon est décrite en détail dans la Demande de Brevet FR-A-2 737 779 intitulée "Dispositif ellipsomètre à haute résolution spatiale", déposée par la Demanderesse le même jour que la présenté Demande sous le N° 95 09779.

Par ailleurs, l'erreur de positionnement des plaques en Z est critique du fait de la résolution spatiale du spot. Cette erreur de positionnement est corrigée de la façon suivante.

En premier lieu, la courbure de chaque type de panneau dans la direction verticale Z est prise en compte en faisant un ajustement, manuel ou autre, du spot d'ellipsométrie.

Après apprentissage, cet ajustement est mémorisé, pour les différentes zones du panneau destinées à être analysées par ellipsométrie. En complément, la cartographie du profil de chaque type de panneau est mise en mémoire dans l'ordinateur GES2 (elle se déduit des ajustements liés à la courbure).

En second lieu, dans la suite du processus de contrôle du traitement de surface, les positions d'impacts ainsi ajustées et mémorisées sont réutilisées à chaque position d'analyse. Elles peuvent également servir pour un traitement laser ultérieur.

Toutefois, cela n'est pas toujours suffisant car des différences de déformations peuvent intervenir entre panneaux de même type.

Un ajustement fin de la position du spot sur la fibre de sortie 5 est obtenu par rotation d'une plaque transparente PT disposée entre l'analyseur 25 et le coupleur d'entrée de la fibre optique 5. Cette rotation est pilotée par les moyens de gestion GES1 de façon à être toujours au maximum de signal sur la barrette du photodétecteur 7.

Cette dernière solution est également décrite dans la Demande de Brevet déposée par la Demanderesse pour "Dispositif ellipsomètre à haute résolution spatiale", mentionnée ci-avant.

Dans le recuit par laser excimère mono-impulsion, l'impulsion laser FLA est d'une durée très faible, par exemple inférieure à 200 nanosecondes. Une telle impulsion fournit très rapidement une énergie suffisante pour atteindre la fusion partielle ou totale d'une couche de silicium amorphe: l'absorption du faisceau laser étant complète après 0,2 micron de pénétration, l'échauffement (avec recristallisation) est d'abord limité à la surface avant, à savoir celle recevant l'impact laser; il s'étend ensuite à l'ensemble de la couche, soit par simple diffusion thermique, soit par un phénomène de cristallisation dit "explosive".

Le seuil d'énergie par unité de surface nécessaire pour obtenir la fusion de la surface avant de la couche de silicium amorphe est ici inférieur à 400 mJ/cm². Au-dessus de cette énergie, la couche de silicium est sujette à une fusion partielle plus étendue. A 500 mJ/cm², la fusion est totale et l'énergie apportée en sus n'est a priori plus utile pour améliorer la recristallisation. Elle peut même être nuisible, car la couche de silicium amorphe peut aussi passer en fusion avec absorption d'énergie trop importante, au-delà de 800 mJ/cm².

Ceci montre l'intérêt d'obtenir, lors du traitement par laser, une caractérisation de la structure de la surface à traiter par ellipsométrie, en vue d'optimiser ledit traitement de surface par laser.

Par ailleurs, la qualité du polysilicium obtenu dépend principalement de la taille et de l'agencement des grains du silicium, et donc du processus de cristallisation lui-même.

Or, la taille moyenne des cristaux du polysilicium obtenus dépend de l'énergie laser appliquée.

En effet, les cristaux de grande taille, qui sont les plus favorables à un fonctionnement optimal du dispositif, sont obtenus dans une gamme très étroite de fluence (ou énergie par unité de surface). Cette gamme correspond aux conditions laser opératoires du laser qui permettent de fondre presque entièrement la couche de silicium amorphe, tout en conservant quelques grains de polysilicium non fondus. Ces grains jouent le rôle de précurseurs de cristallisation dans la recristallisation progressive de la couche fondue et favorisent ainsi l'apparition de cristaux de grande taille. Par contre, en cas de fusion complète et/ou franche de la couche, ces précurseurs disparaissent, et la taille des grains obtenus chute brutalement de un à deux ordres de grandeur.

Ces observations sur le caractère critique du processus de cristallisation mettent en lumière l'intérêt et les avantages que procure la présente invention.

Avantageusement, le procédé de contrôle selon l'invention comprend en outre une étape dans laquelle il est prévu d'optimiser certains au moins des paramètres du traitement par laser selon une loi prédéterminée dépendant au moins en partie de la caractérisation physico-chimique de la surface obtenue par mesure d'ellipsométrie.

Les paramètres essentiels du traitement par laser à contrôler sont la fluence du laser et l'épaisseur de la couche de silicium amorphe à traiter par laser. Cependant, en dehors de la fluence laser et de l'épaisseur initiale de la couche de silicium amorphe, d'autres paramètres peuvent intervenir dans le procédé de contrôle.

Dans certains cas, la structure du matériau à recuire peut être plus complexe qu'une simple couche de silicium amorphe sur substrat de verre. C'est le cas lorsqu'on prévoit une couche transparente (à la bande spectrale d'émission laser), dont le choix judicieux d'épaisseur permet, par simple effet optique, d'accroître sensiblement l'efficacité du traitement laser. Par exemple, l'emploi d'une couche de verre d'épaisseur convenable, par exemple 48 nanomètres, permet d'augmenter l'absorption effective de la couche de silicium amorphe de 0,42 à 0,68, soit un gain de surface traitée d'environ 50% à énergie initiale égale. De plus, l'utilisation d'un verre en silicium Si₃N₄ en lieu et place d'un verre SiO₂ est encore plus favorable puisque le gain en surface traitée est de l'ordre de plus de 100%.

La contrepartie de la présence d'une telle couche antiréflectrice est de rendre le procédé plus complexe et plus difficile à maîtriser, car la fluence optimale dépendra en plus de l'épaisseur de la couche antiréflectrice, et ceci de façon critique.

Par ailleurs, un préchauffage de la couche à traiter par un moyen classique à une température réduite, par exemple 250 à 400°C, permet avantageusement de réduire notablement la fluence nécessaire à la cristallisation. Les tailles des polycristaux obtenues sont légèrement augmentées. Toutefois, le processus est alors plus critique que lorsqu'on fait le traitement laser à température ambiante.

Avantageusement, le procédé de contrôle selon l'invention permet de contrôler avec efficacité cette étape de préchauffage par l'intermédiaire de mesures d'ellipsométrie.

Il est à remarquer que le silicium amorphe déposé par des techniques basses températures, comme le PECVD ("Plasma Enhanced Chemical Vapor Deposition") est rarement exempt d'hydrogène. En effet, de l'emploi d'un mélange de gaz à base de silane pour le dépôt de ce type de couche, il découle que l'on peut difficilement s'affranchir de l'hydrogène toujours présent en grande quantité dans les réacteurs comme sous-produits de la décomposition du silane.

Or, le traitement, sans précaution, d'une couche de silicium amorphe fortement polluée en hydrogène par laser excimère est généralement catastrophique. La libération brutale de l'hydrogène pendant le processus de fusion/cristallisation conduit généralement à une véritable explosion de la couche et/ou à des rugosités de surface finales, ce qui est complètement incompatible avec les performances souhaitées.

Dans ce cas, une solution consiste à effectuer un traitement en deux étapes. Tout d'abord, un impact laser de faible énergie est d'abord appliqué afin de libérer l'hydrogène sans fusion même partielle de la couche de silicium amorphe. Ensuite, le processus de recristallisation est effectué au cours d'un second impact laser de plus forte puissance que le premier (sa puissance est à ajuster compte-tenu des effets du premier impact laser).

Le procédé de contrôle sur site par ellipsométrie spectroscopique selon l'invention trouve encore ici une application avantageuse dans le traitement de couche de silicium polluée en hydrogène.

D'une façon générale, une mesure d'ellipsométrie spectroscopique avant recuit par laser selon l'invention permet de mesurer précisément, les paramètres suivants:
- l'épaisseur de la couche de silicium amorphe: l'épaisseur utilisée se situe entre 30 et 80 nanomètres. Dans cette gamme d'épaisseurs, la précision de l'ellipsométrie est meilleure que 0,5% ;
- l'épaisseur de la couche antireflet: la précision est comparable ou meilleure que obtenue sur la couche de silicium amorphe;
- l'indice optique de la couche de silicium amorphe: la présence d'hydrogène en insertion dans la couche de silicium amorphe induit une diminution de l'indice optique parfaitement sensible en ellipsométrie spectroscopique.

L'utilisation de l'ellipsométrie spectroscopique avant tout traitement selon l'invention permet d'obtenir ainsi une image complète de la structure des échantillons, aussi bien en termes d'épaisseur que pour la composition physico-chimique des couches de silicium amorphe.

En sus de la cristallinité des couches, il est possible de déterminer la rugosité des surfaces des échantillons. En effet, l'apparition d'une rugosité de surface (en particulier après traitement) peut être détectée car elle provoque une déformation des courbes d'ellipsométrie qui est différente de celle induite par une variation d'épaisseur. Cette possibilité est très importante pour le contrôle de procédé de fabrication de panneaux décrit ci-après.

On part de panneaux en verre couverts d'une faible épaisseur en silicium amorphe sensiblement identiques, en particulier de même fabrication (même série). De préférence, le procédé de contrôle de recuit comprend en premier lieu une procédure de test suivie d'une procédure de recuit proprement dit.

La procédure de test comprend les étapes suivantes:
1)- prévoir plusieurs panneaux de test et effectuer pour chacun d'eux, une mesure d'ellipsométrie aux positions des centres des futurs impacts laser;
2)- prévoir une étape de régression (ou autre traitement statistique) des différentes mesures et une évaluation de la structure moyenne des panneaux; il est à noter que dans cette application, les paramètres les plus spécialement évalués sont les épaisseurs des couches, les constantes diélectriques du silicium amorphe et l'homogénéité des panneaux pour le silicium amorphe et la couche antiréflectrice le cas échéant;
3)- estimer l'énergie moyenne du laser nécessaire pour la structure ainsi considérée;
4)- traiter plusieurs panneaux de test avec des énergies dans la gamme ayant une valeur de l'ordre de 0,5 fois l'énergie moyenne, jusqu'à une valeur de l'ordre de 1,5 fois ladite valeur moyenne;
5)- le cas échéant, effectuer une mesure d'ellipsométrie des mêmes panneaux après traitement laser; avantageusement, ceci est complété par une étape de régression des mesures, ainsi que par une évaluation des résultats, afin de déterminer la cristallinité en fonction de l'énergie du laser, l'exactitude des régressions (dans leur ensemble), et la présence de rugosités éventuelles.

Cette procédure de test conduit à une évaluation précise de l'énergie optimale nécessaire pour cristalliser la structure considérée. Dans le cas idéal, cette évaluation peut être validée par une mesure physique complémentaire telle que la résistivité, la cristallinité par rayons X, notamment.

La puissance incidente du laser est ajustée soit par action directe sur l'impulsion laser, soit par un variateur d'énergie tel qu'un atténuateur optique (diaphragme, lame absorbante), un variateur de la tension d'alimentation de la source laser ou de la distance entre les deux lentilles de collection du dispositif optique homogénéiseur.

Dans le cas d'une structure simple silicium amorphe, par exemple avec une épaisseur de 45 nanomètres et du verre traité à température ambiante, la mesure par ellipsométrie avant traitement donne une épaisseur de silicium amorphe de 45 nanomètres avec une variance de l'ordre de 10% due à l'hétérogénéité du dépôt. La présence d'une mince couche d'oxyde natif en surface, par exemple de l'ordre de 2,2 nanomètres doit être prise en compte pour un bon ajustement des mesures. L'indice moyen du silicium amorphe spécifique à ce type d'échantillon est ensuite extrait et comparé aux indices de référence. Dans ce cas précis, l'indice trouvé est très proche de celui d'un silicium amorphe dense, et donc peu susceptible de contenir beaucoup d'hydrogène en insertion. Un traitement classique incluant une seule impulsion laser peut donc être optimisé.

Un certain nombre d'échantillons sont ensuite recuits par laser avec des fluences variables dans la gamme 250 à 370 mJ/cm². Ces échantillons sont analysés par ellipsométrie. Par régression en utilisant l'indice de silicium amorphe extrait précédemment, la cristallinité des divers échantillons est déduite.

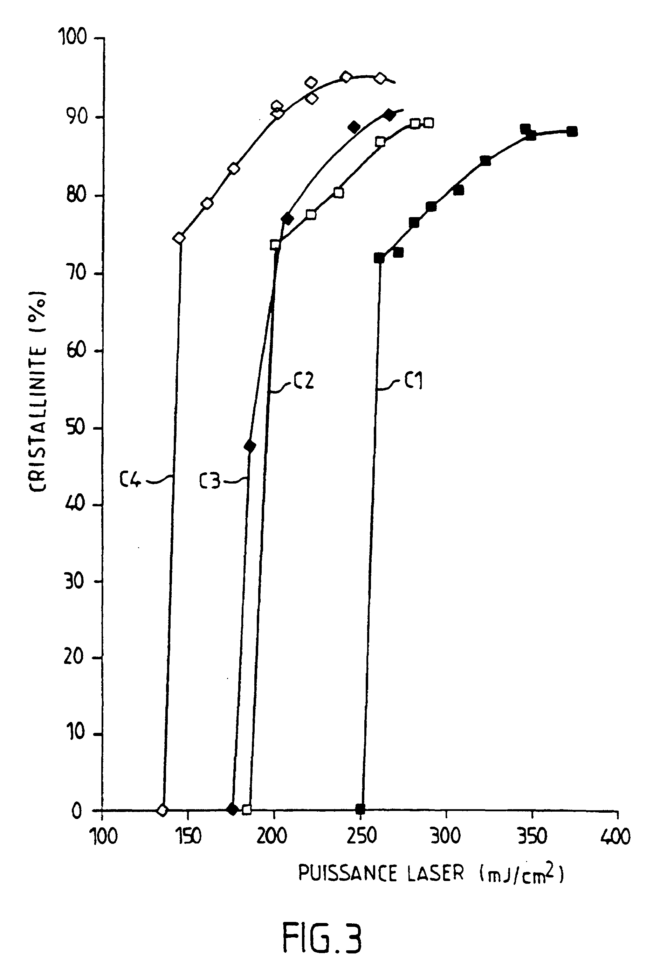

La courbe C1 de cristallinité (figure 3) montre la présence d'un seuil de cristallisation très marqué à environ 255 mJ/cm2. C'est en fait le seuil d'énergie nécessaire à la fusion partielle de la couche de silicium amorphe à température ambiante. Au dessous de ce seuil, la couche entière de silicium apparaît partiellement cristallisée. Le taux de cristallisation augmente progressivement jusqu'à des énergies suffisantes pour que l'ensemble de la couche passe en fusion. Cette évolution est à relier avec la description du processus faite précédemment. L'optimum de traitement est atteint quand le taux de cristallinité mesuré par ellipsométrie spectroscopique est maximal, ici 350 mJ/cm². Cet optimum correspond au meilleur ajustement du modèle à une simple couche homogène, dans l'exemple choisi.

Dans un autre exemple (courbe C3), les échantillons comportent une couche antiréflectrice de silice d'une épaisseur de l'ordre de 55 nanomètres, déposée sur la couche de silicium amorphe. Le processus d'optimisation est effectué de la même manière que précédemment, et la gamme d'énergie choisie est plus faible à cause de la présence de la couche antiréflectrice. Le même type d'analyse après impact laser donne une courbe de cristallinité similaire à la précédente, mais très nettement décalée vers les basses énergies. L'optimum d'énergie est réduit à environ 260 mJ/cm², ce qui correspond au gain d'énergie introduit par simple effet optique.

Il est à remarquer que le contrôle par ellipsométrie spectroscopique est particulièrement intéressant dans le cas complexe à couche antiréflectrice. Cette technique donne de surcroît précisément l'épaisseur de la couche antiréflectrice. Dans d'autres applications, une ellipsométrie à une ou quelques longueurs d'ondes peut suffire.

Par ailleurs, les mêmes types d'échantillons avec et sans couche antiréflectrice ont aussi été recuits par laser sous vide en élevant la température du substrat à environ 240° avec impact. Les mêmes types d'analyses donnent des résultats (courbes C2 et C4) reportés sur la figure 3. Comparé aux résultats obtenus à température ambiante, le préchauffage du substrat permet encore d'abaisser d'environ 50 mJ/cm² l'énergie optimale nécessaire à la cristallisation. Les meilleurs résultats en termes de cristallinité sont apparemment obtenus à 240°C en présence d'une couche antiréflectrice (courbe C4). De surcroît, l'énergie optimale nécessaire est la plus faible, inférieure à 240 mJ/cm², ce qui montre l'intérêt de ces paramètres.

Après la procédure de test destinée à optimiser l'énergie du faisceau laser, le contrôle du recuit proprement dit peut être mis en place.

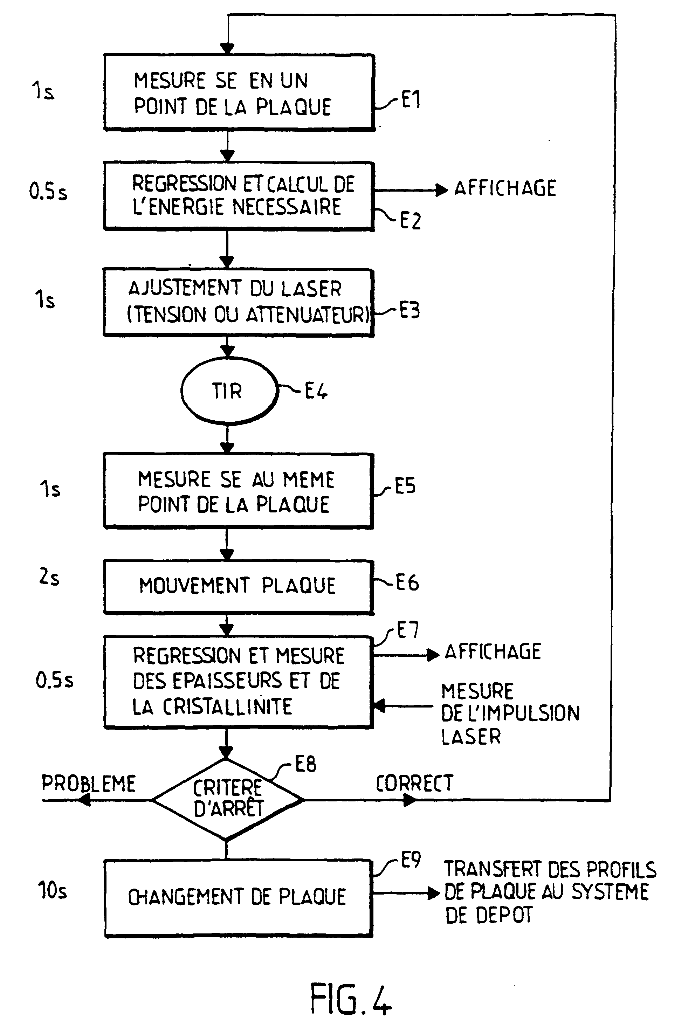

En référence à la figure 4, le procédé de contrôle du recuit par laser comprend les étapes suivantes (pour chaque impact laser sur un panneau) :
- Etape E1: première mesure d'ellipsométrie (durée de l'ordre de 1s, avec l'ajustement en hauteur et un réglage fin, ainsi qu'une acquisition rapide);
- Etape E2: régression et calcul des énergies laser (durée de 0,5s);
- Etape E3: ajustement de l'énergie du laser (durée 1s);
- Etape E4: tir laser;
- Etape E5: le cas échéant, seconde mesure d'ellipsométrie (durée de 1s);
- Etape E6: mouvement du panneau à la position suivante;
- Etape E7: régression et évaluation de la cristallinité;
- Etape E8: test de fin de traitement; et
- Etape E9: changement de panneau ou plaque, et retour à l'étape El.

Par exemple, la période de répétition des impacts laser est de 6s et un panneau de 40 x 30 cm est traité en 9 impulsions, soit une capacité de traitement de l'ordre de 50 panneaux à l'heure, pour les temps indiqués.

Ainsi le procédé décrit permet non seulement d'améliorer la qualité et la fiabilité du recuit laser du silicium amorphe, mais aussi de contrôler a posteriori l'étape de dépôt du silicium amorphe dont l'homogénéité n'est pas toujours parfaite.

Le procédé peut être défini en d'autres termes comme suit:
- a) effectuer, avant ledit traitement de surface par laser, au moins une mesure d'ellipsométrie sur l'une des zones à traiter d'un panneau immobilisé dans une position initiale définie par trois coordonnées relativement à un référentiel orthonormé (X,Y,Z), afin d'obtenir un multiplet de caractéristiques physico-chimiques sur sa surface,
- b) déterminer l'énergie du faisceau laser nécessaire au traitement, en fonction au moins du multiplet de caractéristiques obtenu à l'étape a) et d'une table de correspondance mémorisée,
- c) effectuer un tir laser d'énergie déterminée à l'étape b) afin de traiter la surface de la zone,
- d) déplacer le panneau dans le plan XY de sorte qu'une autre zone soit positionnée en regard du faisceau laser, et
- e) recommencer le procédé au moins à l'étape c).

Mieux encore, à l'étape a) on effectue une mesure d'ellipsométrie sur chaque zone à traiter sur le panneau, afin d'obtenir le multiplet de caractéristiques physico-chimiques de la surface de chaque zone à traiter, tandis qu'à l'étape b) la détermination de l'énergie du faisceau laser nécessaire au traitement est effectuée en fonction de tous les multiplets de caractéristiques obtenus à l'étape a).

Le cas échéant, à l'étape d), le positionnement comprend une sous-étape d1) dans laquelle on effectue une mesure d'ellipsométrie sur la zone, afin d'ajuster son positionnement selon la direction Z.

Selon une variante, entre les étapes d) et e) on prévoit une étape intermédiaire d') dans laquelle on ajuste l'énergie du laser nécessaire au traitement de surface de la zone, en fonction de l'énergie déterminée à l'étape b), de l'ajustement en position effectué à la sous-étape dl) et de la table de correspondance.

Selon une autre variante, entre les étapes c) et d) on prévoit une sous-étape c') dans laquelle on effectue une mesure d'ellipsométrie de la surface traitée, afin de déterminer les nouvelles caractéristiques du multiplet.

Dans sa version évoluée, le procédé peut être défini comme suit:
- a) effectuer une mesure d'ellipsométrie sur chaque zone à traiter sur un panneau immobilisé dans une position initiale, avant ledit traitement de surface par laser, afin d'obtenir un multiplet de caractéristiques physico-chimiques de la surface à traiter sur chaque zone,
- b) évaluer l'énergie moyenne du laser nécessaire au traitement de surface moyen du panneau, en fonction des caractéristiques obtenues à l'étape a) et d'une table de correspondance mémorisée, et
   ensuite, pour chaque zone à traiter :
- c) effectuer une nouvelle mesure d'ellipsométrie sur la zone, afin d'ajuster son positionnement par rapport à la position initiale,
- d) ajuster l'énergie du laser nécessaire au traitement de surface de la zone, en fonction de l'énergie moyenne évaluée à l'étape b), de l'ajustement en position effectué à l'étape c) et de la table de correspondance, et
- e) effectuer un tir laser d'énergie déterminée à l'étape d) afin de traiter la zone.

En toutes ses présentations de procédé, il est également possible de pourvoir un dispositif correspondant.

## Revendications

1. Procédé de traitement de surface par laser, dans lequel on dispose d'une série d'au moins deux zones distinctes, sensiblement semblables sur le plan physico-chimique et comprenant chacune une couche de silicium, de profondeur donnée, et sur chacune desquelles doit être appliqué, en une ou plusieurs fois, un faisceau laser d'énergie choisie pour recristalliser la couche de silicium desdites zones, **caractérisé en ce qu'**il comprend les étapes suivantes:
- a) effectuer, avant l'une au moins des applications du faisceau laser sur la première zone, au moins une mesure d'ellipsométrie sur ladite première zone, afin d'obtenir un multiplet de caractéristiques physico-chimiques de ladite première zone,
- b) déterminer l'énergie du faisceau laser nécessaire à la recristallisation de la couche de silicium de la première zone, en fonction au moins du multiplet de caractéristiques obtenu à l'étape a) et d'une table de correspondance mémorisée,
- c) effectuer, sur la première zone, au moins un tir laser d'énergie déterminée à l'étape b),
- d) positionner la seconde zone en regard du faisceau laser, et
- e) effectuer, sur la seconde zone, au moins un tir laser d'énergie déterminée à l'étape b), ce qui permet d'optimiser le processus de recristallisation du silicium par laser sur ladite série de zones en maîtrisant l'application de l'énergie laser à l'aide de la mesure d'ellipsométrie.

2. Procédé selon la revendication 1, **caractérisé en ce qu'**à l'étape a) on effectue une mesure d'ellipsométrie au moins aussi sur la seconde zone à traiter, afin d'obtenir le multiplet de caractéristiques physico-chimiques de la surface des première et seconde zones à traiter, et **en ce qu'**à l'étape b) la détermination de l'énergie du faisceau laser nécessaire au traitement est effectuée en fonction de tous les multiplets de caractéristiques obtenus à l'étape a).

3. Procédé selon la revendication 1, **caractérisé en ce qu'**entre les étapes d) et e) on prévoit une étape intermédiaire d') dans laquelle on ajuste l'énergie du laser nécessaire au traitement de surface de la seconde zone, en fonction de l'énergie déterminée à l'étape b), et de la table de correspondance.

4. Procédé selon la revendication 1, dans lequel la première zone est immobilisée dans une position initiale définie par trois coordonnées relativement à un référentiel orthonormé (X,Y,Z), **caractérisé en ce qu'**à l'étape d) le positionnement de la seconde zone comprend un déplacement de ladite seconde zone dans le plan XY.

5. Procédé selon la revendication 4, **caractérisé en ce qu'**à l'étape d) le positionnement de la seconde zone comprend en outre une sous-étape d1) dans laquelle on effectue une mesure d'ellipsométrie sur la seconde zone, afin d'ajuster son positionnement selon la direction Z.

6. Procédé selon les revendications 5, **caractérisé en ce que** l'ajustement de l'énergie du laser nécessaire au traitement de surface de la seconde zone, est réalisé en fonction de l'énergie déterminée à l'étape b), de l'ajustement en position effectué à la sous-étape d1) et de la table de correspondance.

7. Procédé selon l'une des revendications 1 à 6, **caractérisé en ce qu'**entre les étapes c) et d) on prévoit une sous-étape c') dans laquelle on effectue une mesure d'ellipsométrie de la première zone traitée, afin de déterminer les nouvelles caractéristiques du multiplet.

8. Procédé selon l'une des revendications précédentes,
**caractérisé en ce que** la mesure d'ellipsométrie est spectroscopique.

9. Procédé selon l'une des revendications 1 à 7, **caractérisé en ce que** la mesure d'ellipsométrie est effectuée à une ou quelques longueurs d'ondes.

10. Procédé selon l'une des revendications 1 à 9, **caractérisé en ce que** la caractérisation physico-chimique de chaque zone par ellipsométrie comprend la mesure de l'un au moins des paramètres appartenant au groupe formé par l'épaisseur de cette zone, la densité et l'indice optique de cette zone, l'épaisseur des différentes couches présentes en cette zone, et la composition physico-chimique de cette zone.

11. Procédé selon l'une des revendications précédentes, **caractérisé en ce que** chaque zone à traiter comprend sur une couche de silicium amorphe déposée sur un substrat.de verre et une couche supérieure constituée d'un matériau présentant des caractéristiques optiques anti-reflet déposée sur la face supérieure de la couche de silicium amorphe opposée au substrat.

12. Dispositif de traitement de surface par laser, pour la mise en oeuvre du procédé selon l'une des revendications précédentes, ledit dispositif étant **caractérisé en ce qu'**il comprend un ellipsomètre (EL) propre à effectuer, avant l'une au moins des applications du faisceau laser sur la première zone, au moins une mesure d'ellipsométrie sur ladite première zone, afin d'obtenir un multiplet de caractéristiques physico-chimiques de ladite première zone, des moyens de calcul (GES1,GES2) pour déterminer l'énergie du faisceau laser nécessaire à la recristallisation de la couche de silicium de la première zone, en fonction au moins du multiplet de caractéristiques ainsi obtenu et d'une table de correspondance mémorisée, des moyens (LA) pour effectuer, sur la première zone, au moins un tir laser d'énergie ainsi déterminée par les moyens de calcul, des moyens (TAB) pour positionner la zone suivante en regard du faisceau laser, les moyens (LA) étant propres à effectuer sur la seconde zone au moins un tir laser d'énergie déterminée par les moyens de calcul sur la première zone.

## Patentansprüche

1. Verfahren zur Oberflächenbearbeitung mit Laser,
wobei eine Reihe von mindestens zwei getrennten, in physikalisch-chemischer Hinsicht im Wesentlichen gleichartigen Bereichen zur Verfügung steht, die jeweils eine Siliziumschicht mit einer bestimmten Tiefe umfassen, und wobei auf jede einmalig oder mehrmalig ein Laserstrahl von ausgewählter Energie angewendet wird, um die Siliziumschicht der Bereiche zu rekristallisieren,
**dadurch gekennzeichnet, dass**
es die folgenden Schritte umfasst:
a) Vornehmen von mindestens einer Ellipsometriemessung am ersten Bereich vor mindestens einer Anwendung des Laserstrahls an dem ersten Bereich, um ein Multiplett physikalisch-chemischer Eigenschaften des ersten Bereichs zu erhalten,
b) Bestimmen der Energie des Laserstrahls, die zur Rekristallisierung der Siliziumschicht des ersten Bereichs notwendig ist, in Abhängigkeit von zumindest dem Multiplett von Eigenschaften, das in Schritt a) erhalten wurde, und einer gespeicherten Zuordnungstabelle,
c) Beaufschlagen des ersten Bereichs mit mindestens einem Laserbeschuss mit der in Schritt b) bestimmten Energie,
d) Positionieren des zweiten Bereichs im Hinblick auf den Laserstrahl, und
e) Beaufschlagen des zweiten Bereichs mit mindestens einem Laserbeschuss mit der in Schritt b) bestimmten Energie, wodurch der Rekristallisierungsprozess des Siliziums mittels Laser an der Reihe von Bereichen optimiert werden kann, wobei das Anwenden der Laserenergie mittels der Ellipsometriemessung gesteuert wird.

2. Verfahren nach Anspruch 1,
**dadurch gekennzeichnet, dass**
in Schritt a) eine Ellipsometriemessung mindestens auch am zweiten zu bearbeitenden Bereich durchgeführt wird, um das Multiplett von physikalisch-chemischen Eigenschaften der Oberfläche des ersten und zweiten zu bearbeitenden Bereichs zu erhalten, und wobei in Schritt b) die Bestimmung der Energie des zur Bearbeitung notwendigen Laserstrahls in Abhängigkeit von allen Multipletten von Eigenschaften vorgenommen wird, die in Schritt a) erhalten wurden.

3. Verfahren nach Anspruch 1,
**dadurch gekennzeichnet, dass**
zwischen den Schritten d) und e) ein Zwischenschritt d') vorgesehen ist, bei dem die zur Oberflächenbearbeitung des zweiten Bereichs notwendige Laserenergie in Abhängigkeit von der in Schritt b) bestimmten Energie und der Zuordnungstabelle eingestellt wird.

4. Verfahren nach Anspruch 1,
wobei der erste Bereich in einer Ausgangsposition festgesetzt wird, die durch drei Koordinaten bezüglich eines orthonormierten Bezugssystems (X, Y, Z) bestimmt ist,
**dadurch gekennzeichnet, dass**
in Schritt d) die Positionierung des zweiten Bereichs eine Verschiebung des zweiten Bereichs in der X-Y-Ebene umfasst.

5. Verfahren nach Anspruch 4,
**dadurch gekennzeichnet, dass**
in Schritt d) die Positionierung des zweiten Bereichs darüber hinaus einen Teilschritt d1) umfasst, wobei eine Ellipsometriemessung am zweiten Bereich vorgenommen wird, um dessen Positionierung in der Z-Richtung einzustellen.

6. Verfahren nach Anspruch 5,
**dadurch gekennzeichnet, dass**
die Einstellung der für die Oberflächenbearbeitung des zweiten Bereichs notwendigen Energie des Lasers in Abhängigkeit von der in Schritt b) bestimmten Energie, von der im Teilschritt d1) vorgenommenen Positionseinstellung und von der Zuordnungstabelle durchgeführt wird.

7. Verfahren nach einem der Ansprüche 1 bis 6,
**dadurch gekennzeichnet, dass**
zwischen den Schritten c) und d) ein Teilschritt c') vorgesehen ist, in dem eine Ellipsometriemessung des ersten Bereichs vorgenommen wird, um die neuen Eigenschaften des Multipletts zu bestimmen.

8. Verfahren nach einem der vorhergehenden Ansprüche,
**dadurch gekennzeichnet, dass**
die Ellipsometriemessung spektroskopisch ist.

9. Verfahren nach einem der Ansprüche 1 bis 7,
**dadurch gekennzeichnet, dass**
die Ellipsometriemessung bei einer oder mehreren Wellenlängen vorgenommen wird.

10. Verfahren nach einem der Ansprüche 1 bis 9,
**dadurch gekennzeichnet, dass**
die physikalisch-chemische Charakterisierung von jedem Bereich durch Ellipsometrie die Messung mindestens eines Parameters umfasst, der zur Gruppe gehört, die aus der Dicke dieses Bereichs, der Dichte und dem optischen Index dieses Bereichs, der Dicke der verschiedenen, auf diesem Bereich vorhandenen Schichten und der physikalisch-chemischen Zusammensetzung dieses Bereichs besteht.

11. Verfahren nach einem der vorhergehenden Ansprüche,
**dadurch gekennzeichnet, dass**
jeder zu bearbeitende Bereich auf einer Schicht aus amorphem Silizium, die auf einem Glassubstrat abgeschieden ist, eine darüber liegende Schicht umfasst, die aus einem Material besteht, das optische Entspiegelungseigenschaften aufweist, die auf der oberen Seite der Schicht aus amorphem Silizium, dem Substrat gegenüber liegend, abgeschieden ist.

12. Vorrichtung zur Oberflächenbearbeitung mittels Laser zum Durchführen des Verfahrens nach einem der vorhergehenden Ansprüche,
**dadurch gekennzeichnet, dass**
die Vorrichtung Folgendes aufweist:
- ein Ellipsometer (EL), das sich dazu eignet, vor mindestens einem der Anlegevorgänge des Laserstrahls auf den ersten Bereich mindestens eine Ellipsometriemessung am ersten Bereich vorzunehmen, um ein Multiplett von physikalisch-chemischen Eigenschaften des ersten Bereichs zu erhalten,
- Berechnungseinrichtungen (GES1, GES2), um die zur Rekristallisierung der Siliziumschicht des ersten Bereichs notwendige Energie des Laserstrahls in Abhängigkeit von zumindest dem auf diese Weise erhaltenen Multiplett von Eigenschaften und einer gespeicherten Zuordnungstabelle zu bestimmen,
- Einrichtungen (LA), um den ersten Bereich mit mindestens einem Laserbeschuss mit der von den Berechnungseinrichtungen auf diese Weise bestimmten Energie zu beaufschlagen,
- Einrichtungen (TAB), um den nächsten Bereich im Hinblick auf den Laserstrahl zu positionieren, wobei sich die Einrichtungen (LA) dazu eignen, den zweiten Bereich mit mindestens einem Laserbeschuss mit der durch die Berechnungseinrichtungen am ersten Bereich bestimmten Energie zu beaufschlagen.

## Claims

1. Laser surface treatment method in which a series of at least two distinct zones are employed that are substantially identical as regards physico-chemical properties and each comprising a silicon layer of given depth, and to each of which there is to be applied, once or several times, a laser beam of energy chosen so as to recrystalise the silicon layer of the said zones, **characterised in that** the method comprises the following steps:
a) carrying out, before at least one of the applications of the laser beam to the first zone, at least one ellipsometry measurement on the said first zone so as to obtain a set of physico-chemical characteristics of the said first zone,
b) determining the energy of the laser beam necessary for the recrystallisation of the silicon layer of the first zone, as a function of at least the set of characteristics obtained in step a) and of a stored correspondence table,
c) subjecting the first zone to at least one pulse of laser energy of magnitude determined in step b),
d) positioning the second zone with respect to the laser beam, and
e) subjecting the second zone to at least one pulse of laser energy of magnitude determined in step b), which enables the process of recrystallisation of silicon by laser on the said series of zones to be optimised by controlling the application of the laser energy with the aid of the ellipsometry measurement.

2. Method according to claim 1, **characterised in that** in step a) an ellipsometry measurement is carried out at least also on the second zone to be treated, so as to obtain the set of physico-chemical characteristics of the surface of the first and second zones to be treated, and **in that** in step b) the energy of the laser beam necessary for the treatment is determined as a function of all the sets of characteristics obtained in step a).

3. Method according to claim 1, **characterised in that** between the steps d) and e) an intermediate step d') is provided in which the energy of the laser necessary for the treatment of the surface of the second zone is adjusted as a function of the energy determined in step b) and as a function of the correspondence table.

4. Method according to claim 1, in which the first zone is fixed in an initial position defined by three co-ordinates relative to an orthogonal frame of reference (X,Y,Z), **characterised in that** in step d) the positioning of the second zone comprises a displacement of the said second zone in the XY plane.

5. Method according to claim 4, **characterised in that** in step d) the positioning of the second zone moreover comprises a sub-step d1) in which an ellipsometry measurement is carried out on the second zone so as to adjust its positioning along the Z direction.

6. Method according to claim 5, **characterised in that** the adjustment of the laser energy necessary for the surface treatment of the second zone is carried out as a function of the energy determined in step b), of the position adjustment effected in sub-step d1), and of the correspondence table.

7. Method according to one of claims 1 to 6,
**characterised in that** between the steps c) and d) a sub-step c') is carried out in which an ellipsometry measurement of the first treated zone is carried out so as to determine the new characteristics of the set.

8. Method according to one of the preceding claims,
**characterised in that** the ellipsometry measurement is a spectroscopic measurement.

9. Method according to one of claims 1 to 7,
**characterised in that** the ellipsometry measurement is carried out at one or several wavelengths.

10. Method according to one of claims 1 to 9,
**characterised in that** the physico-chemical characterisation of each zone by ellipsometry comprises measuring at least one of the parameters belonging to the group consisting of the thickness of this zone, the density and optical index of this zone, the thickness of the different layers present in this zone, and the physico-chemical composition of this zone.

11. Method according to one of the preceding claims,
**characterised in that** each zone to be treated comprises a layer of amorphous silicon deposited on a glass substrate and an upper layer consisting of a material having anti-reflection optical characteristics deposited on the upper face of the layer of amorphous silicon opposite the substrate.

12. Laser surface treatment device for the implementation of the method according to one of the preceding claims, the said device being **characterised in that** it comprises an ellipsometer (EL) capable of carrying out, before at least one of the applications of the laser beam to the first zone, at least one ellipsometry measurement on the said first zone so as to obtain a set of physico-chemical characteristics of the said first zone, calculating means (GES1, GES2) for determining the energy of the laser bean necessary for the recrystallisation of the silicon layer of the first zone, as a function of at least the set of characteristics thus obtained and of a stored correspondence table, means (LA) for subjecting the first zone to at least one pulse of laser energy of magnitude determined by the calculating means, means (TAB) for positioning the following zone with respect to the laser beam, the means (LA) being capable of subjecting the second zone to at least one pulse of laser energy of magnitude determined by the calculating means employed for the first zone.
